# EUROPEAN PATENT APPLICATION

(11) **EP 4 752 587 A1**
(43) Date of publication of application: **03.06.2026**
(21) Application number: 24216553.8
(22) Date of filing: 29.11.2024
(51) Int. Cl.: G01R 33/561, G01R 33/48, G01R 33/56, G01R 33/565

(54) **ENHANCED ECHO-PLANAR MAGNETIC RESONANCE IMAGING**

(71) Applicant: Siemens Healthineers AG, 91301 Forchheim (DE)
(72) Inventor: Liu, Wei, 91052 Erlangen (DE)
(74) Representative: Siemens Healthineers Patent Attorneys

(57) **Abstract**

A method according to the invention to acquire scan data of a region of interest of an examination object by means of an echo-planar (EPI) technique, comprises the steps of:
- acquiring and recording a first set of scan data in at least two shots using a flyback trajectory,
- acquiring and recording a second set of scan data using the same flyback trajectory used for the first set of scan data, but with a starting point of the flyback trajectory shifted in the phase-encoding direction.

By acquiring and recording the second set of scan data with the same flyback trajectory only with a shifted starting point both Nyquist ghosting and flow ghosting can be improved without changing a necessary echo spacing, thereby also reducing imaging distortion and chemical shift, and without changing the bipolar readout gradient. A full set (according to Nyquist) of all k-space lines can be yielded for each polarity of the bipolar readout gradient.

## Description

The invention relates to an enhanced echo-planar magnetic resonance imaging technique.

Magnetic resonance technology (hereinafter, the abbreviation MR stands for magnetic resonance) is a known technology with which images of the interior of an examination object can be generated. Expressed simply, for this purpose, the examination object is positioned in a magnetic resonance device in a relatively strong, static, homogeneous main magnetic field, also known as the B0 field, with field intensities of 0.2 tesla to 7 tesla or more, so that its nuclear spins become oriented along the main magnetic field. In order to trigger nuclear spin resonances that are measurable as signals, high frequency excitation pulses (RF pulses) are radiated into the examination object and the nuclear spin resonances produced are measured as so-called k-space data and, on the basis thereof, MR images are reconstructed or spectroscopic data is established. For position encoding of the scan data, rapidly switched magnetic gradient fields, known as gradients for short, are overlaid on the main magnetic field. A scheme that is used which defines a temporal sequence of RF pulses to be radiated in and gradients to be switched is known as a pulse sequence (scheme) or sequence for short. The recorded scan data is digitized and stored as complex number values in a k-space matrix. From the k-space matrix occupied with values, an associated MR image can be reconstructed, for example, by means of a multi-dimensional Fourier transform.

One of the fastest known MR recording techniques is so-called echo-planar imaging (EPI), in which following an RF excitation pulse, an oscillating, that is bipolar, readout gradient is used in which each change of the polarization direction of the gradient refocuses the transverse magnetization as far as the T2* decay allows, and thereby generates a gradient echo. In other words, by way of the switching of the bipolar readout gradient following an RF excitation pulse within the free induction decay (FID) following the excitation or, if additionally an RF refocusing pulse is radiated in following the RF excitation pulse, within the thereby generated spin echo, an echo sequence of rising and falling gradient echoes with alternating sign is generated. EPI techniques can employ a series of such bipolar readout gradients to generate a train of gradient echoes. With an accompanying phase-encoding gradient, each gradient echo is spatially encoded uniquely, allowing multiple k-space lines to be sampled within the envelope of a FID or a spin echo. Unlike rapid acquisition with relaxation enhancement (RARE), EPI uses a gradient-echo train instead of an RF spin echo train to accelerate data acquisition. Because gradient echoes can be produced much faster than RF spin echoes, EPI generates images in significantly less time. The EPI pulse sequence can be used for either 2D or 3D acquisition, with either "single-shot", in which all the scan data for generating an image of a subvolume, e.g. a slice of the examination object under investigation, is recorded following just one RF excitation pulse, or multiple-shot configurations, in which data is acquired after multiple RF excitation pulses.

Compared to conventional spin-echo and gradient-echo imaging, EPI techniques are more prone to a variety of artifacts.
1. Nyquist Ghosting: This artifact appears along the phase-encoding direction and is well-known in EPI techniques. EPI techniques use bipolar gradients to alternately acquire odd and even echoes, requiring k-space data to be flipped along the readout direction for every other acquired line to ensure all k-space lines point in the same direction. This flipping often introduces inconsistent phase errors caused by eddy currents, B0-field inhomogeneity, and concomitant magnetic fields. These phase errors alternate between even and odd echoes, leading to Nyquist ghosting along the phase-encoding direction.
2. Chemical Shift Artifact: In EPI techniques, the chemical shift artifact has a unique manifestation. Unlike in conventional spin-echo and gradient-echo imaging, the displacement caused by chemical shift is typically negligible along the EPI readout direction but more pronounced along the phase-encoded direction. This is because the bandwidth along the phase-encoding direction is much lower with EPI techniques than in conventional spin-echo and gradient-echo sequences.
3. Image Distortion: This artifact is occurring in EPI techniques especially in regions with off-resonance effects, such as field inhomogeneity, magnetic susceptibility variations, eddy currents with long time constants, and concomitant magnetic fields. B0-field inhomogeneities can severely distort images and lead to significant signal loss.
4. Flow Artifacts: These artifacts must be considered, e.g. when EPI techniques are used for cardiac imaging or time-of-flight (TOF) imaging. Ghosting and signal loss caused by flow along the readout direction are particularly problematic in these applications as has been described in the article of G. T. Luk Pat et al, "Reducing flow artifacts in Echo-Planar Imaging", Magn. Reson. Med. 37, p. 436-447 (1997).

Many methods have been proposed to mitigate Nyquist ghosts. The most common approach utilizes calibration data acquired without a phase-encoding gradient to measure the inconsistent phase errors between odd and even echoes in the echo train as e.g. described in US6043651. However, this method typically only corrects constant and linear phase errors, leaving residual ghost artifacts caused by higher-order phase errors. Another common technique is the so-called skip-echo EPI technique, also known as flyback EPI technique, which acquires every other echo in the EPI echo train. This method avoids alternating phase errors and amplitude modulation in k-space data along the phase-encoded direction because only echoes with the same polarity are used in reconstruction.

The chemical shift results in a spatial shift along the phase-encoded direction, which is proportional to the echo spacing. In single-shot acquisition, the bandwidth in the phase-encoding direction is typically around 1 kHz, leading to a significant shift. Therefore, fat suppression is usually necessary in these cases. For multi-shot EPI acquisitions, the shift can be negligible if enough shots are acquired.

Imaging distortion can be effectively reduced by decreasing the echo spacing or the echo train length, as in multi-shot EPI techniques. Another common solution to image distortion is to first acquire or estimate a B0 map for a later correction.

Flow artifacts in the readout direction can also be addressed by using a flyback trajectory in the acquisition scheme, in which all acquired echoes are fully flow-compensated in the readout direction by placing a single flow-compensated readout gradient in front of the echo train as has been described in the article of J. L. Duerk et al. "Theoretical aspects of motion sensitivity and compensation in echo-planar imaging", J. Magn. Reson. Imag. 1, p. 643-650 (1991).

As discussed above, using a flyback scheme in EPI techniques can eliminate both ghost artifacts and flow artifacts caused by flow along the readout direction. However, it increases echo spacing and nearly doubles the scan time. To minimize echo spacing, the readout gradient for skipped echoes can be maximized, reducing duration but complicating sequence design when considering flow compensation in the readout direction. Additionally, prolonged echo spacing exacerbates chemical shift and imaging distortion.

Therefore, there is still a need for enhanced EPI techniques that avoid or reduce artifacts, in particular the artifacts listed above. Therefore, it is an object of the described technique to overcome the still existing limitations and allow enhanced EPI techniques to be employed.

The object is achieved by a method to acquire scan data of a region of interest of an examination object by means of an echo-planar (EPI) technique according to claim 1, as well as a magnetic resonance system, a computer program, and an electronically readable data carrier according to dependent claims.

A method according to the invention to acquire scan data of a region of interest of an examination object by means of an echo-planar (EPI) technique, comprises the steps of:
- acquiring and recording a first set of scan data in at least two shots using a flyback trajectory,
- acquiring and recording a second set of scan data using the same flyback trajectory used for the first set of scan data, but with a starting point of the flyback trajectory shifted in the phase-encoding direction.

By acquiring and recording the second set of scan data with the same flyback trajectory only with a shifted starting point both Nyquist ghosting and flow ghosting can be improved without changing a necessary echo spacing, thereby also reducing imaging distortion and chemical shift, and without changing the bipolar readout gradient. A full set (according to Nyquist) of all k-space lines can be yielded for each polarity of the bipolar readout gradient.

The proposed method can be easily and flexibly implemented enhancing all existing EPI techniques, whether 2D or 3D, with linear or centric reordering.

Particularly, for flow-sensitive applications, like time-of-flight (TOF) imaging, full flow compensation in the readout direction can be easily achieved without altering the flow compensation scheme throughout the EPI sequence for both sets of scan data. For instance, if the shot acquisition would be simply repeated without echo shifting, an additional flow compensation would be necessary for the second set of scan data to collect all echoes with the same polarity and achieve full flow compensation along the readout direction.

A magnetic resonance system according to the invention comprises a magnet unit, a gradient unit, a high frequency unit and a control apparatus with a correction data determining unit designed for carrying out a method according to the invention.

A computer program according to the invention implements a method according to the invention on a control apparatus when it is executed on the control apparatus.

Herein, the computer program can also be available in the form of a computer program product which is directly loadable into a memory store of a control apparatus, having program code means in order to carry out a method according to the invention when the computer program product is executed in the computing unit of the computing system.

An electronically readable data carrier according to the invention comprises electronically readable control information stored thereon, which comprises at least one computer program according to the invention and is configured such that, when the data carrier is used in a control apparatus of a magnetic resonance system, it carries out a method according to the invention.

The advantages and embodiments set out in relation to the method apply accordingly to the magnetic resonance system, the computer program product and the electronically readable data carrier.

Further advantages and details of the present invention are disclosed in the exemplary embodiments described below and by reference to the drawings. The examples given do not represent restrictions of the invention. In the drawings:
Fig. 1 shows a schematic flow diagram of a method according to the invention,
Fig. 2 shows a schematic pulse sequence diagram for an EPI technique that could be used to record scan data according to the invention,
Figs. 3-4 show schematic representations of exemplary flyback trajectories in k-space along which with scan data can be acquired,
Fig. 5 shows a schematic representation of a magnetic resonance system according to the invention.

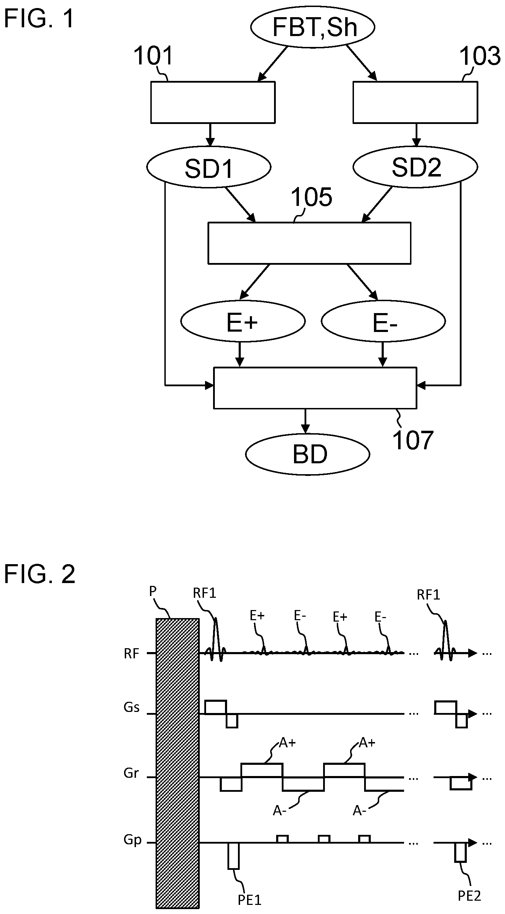

Figure 1 shows a schematic flow diagram of the proposed method to acquire scan data of a region of interest of an examination object by means of an echo-planar (EPI) technique.

A first set of scan data SD1 is acquired and recorded in at least two shots using a flyback trajectory FBT (block 101). Here, any known flyback trajectory can be used. Some examples are given below. The EPI technique used can be a three-dimensional (3D) EPI technique or a two-dimensional (2D) EPI technique. The described technique can be applied either way.

A second set of scan data SD2 is acquired and recorded using the same flyback trajectory FBT used for the first set of scan data SD1, but with a starting point of the flyback trajectory shifted in the phase-encoding direction according to a shift Sh (block 103).

Figure 2 shows a schematic pulse sequence diagram for an EPI technique that could be used to record scan data according to the invention. In the uppermost line RF applied RF excitation pulses RF1 and a train of echo signals E+, E- are shown. The next lines show gradients that can be applied in the slice-encoding direction Gs, in the readout direction Gr and in the phase-encoding direction Gp. In the depicted example a gradient is applied during the application of the RF excitation pulse for slice-selection. In the readout direction Gr an exemplary bipolar readout gradient with alternating polarities A+ and A- is shown. In the phase-encoding direction an exemplary pre-phaser gradient PE1 and following gradient blips, shifting the trajectory from one k-space line to the next, can be seen. After another application of an RF excitation pulse, i.e. another shot, a next echo train can be acquired and recorded. For a typical flyback trajectory the pre-phaser gradient PE2 of the next shot would place the first k-space line acquired after this pre-phaser gradient PE2 at a position of a k-space line that was skipped during the preceding echo train but otherwise keep the phase-encoding blips and the readout gradient. The pre-phaser PE2 gradient following the first RF excitation pulse RF1 after which scan data for the second set of scan data is to be acquired and recorded can be chosen to yield the shift Sh. Thus, the shift Sh can be induced by a pre-phaser gradient in phase-encoding direction applied before the recording of the second set of scan data using the flyback trajectory.

Additionally, it is possible to prepare the acquisition during a preparation period P, e.g. to apply flow-compensation gradients and/or to saturate chosen saturation bands in front of a region of interest in the readout direction to prevent flow artifacts.

Thus, at least one flow-compensation gradient as known in the art can be applied before an echo train within the recording of scan data of the first and/or second set of scan data, so that the acquisition of the scan data is flow-compensated.

Also, it is possible to apply a saturation band before the recording of scan data to reduce inflowing signal in the readout direction as is known in the art.

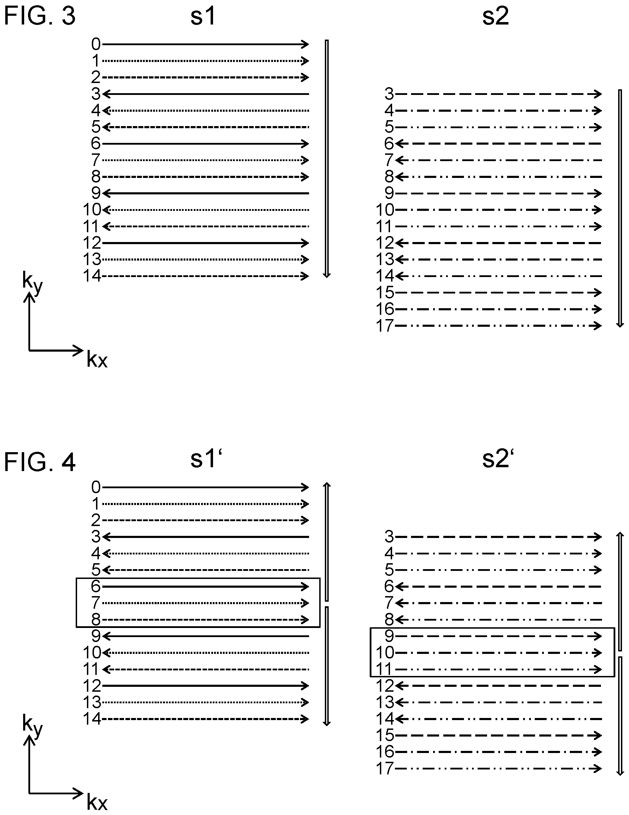

Figures 3 and 4 show schematic representations of exemplary flyback trajectories in k-space along which with scan data can be acquired as a first set s1 of scan data and a second set s2 of scan data as described herein.

The example of figure 3 depicts a three-shot flyback trajectory with five echoes acquired with linear ordering in each shot for each set s1 and s2 of scan data SD1, SD2. The flyback trajectory used as an example here thus is a flyback trajectory with linear reordering.

The numbers left of the depicted k-space lines indicate the respective line index. The arrows at the ends of the k-space lines indicate the direction in which the respective k-space line was scanned. All lines acquired within one shot are depicted with a same type of line (continuous line, dashed line,...). The arrows on the right sides indicate the direction of the progress of the acquisition in phase-encoding direction.

As can be seen, the k-space lines in the example of figure 3 in the
first set s1 of scan data SD1 are acquired in the following order given by their index:
fist shot: 0-3-6-9-12, second shot: 1-4-7-10-13, third shot: 2-5-8-11-14.

In this first set s1 of scan data SD1, the line indices 0, 1, 2, 6, 7, 8, 12, 13, 14 are acquired with positive polarity, i.e. in the direction of the readout direction, and the line indices 3, 4, 5, 9, 10, 11 are acquired with negative polarity, i.e. in negative readout direction.

As described herein, a second set s2 of scan data SD2 is acquired and recorded. This second set s2 of scan data SD2 can be acquired and recorded in direct succession of the acquisition and recording of the first set s1 of scan data SD1. In the example of figure 3 the k-space lines of this second set s2 of scan data SD2 are acquired in the following order given by their index: first shot 3-6-9-12-15, second shot: 4-7-10-13-16, third shot: 5-8-11-14-17.

In this second set s2 of scan data SD2 , the line indices 3, 4, 5, 9, 10, 11, 15, 16, 17 are acquired with positive polarity, i.e. in the direction of the readout direction, and the line indices 6, 7, 8, 12, 13, 14 are acquired with negative polarity, i.e. in negative readout direction.

The shift Sh in the phase-encoding direction by which the starting point of the flyback trajectory is shifted between the recording of the first set of scan data SD1 and the second set of scan data SD2 can be chosen such that it equals a phase-shift between two consecutively recorded k-space lines in the flyback trajectory. Thus same k-space indices will be acquired and recorded in the first set s1 of scan data SD1 and in the second set s2 of scan data SD2 while the polarization of same indices acquired in the first set s1 of scan data SD1 and the second set s2 of scan data SD2 will be opposed.

The example of figure 4 depicts a six-shot flyback trajectory with centric ordering and with three echoes acquired in each shot for each set s1' and s2' of scan data SD1, SD2. The flyback trajectory used as an example here thus is a flyback trajectory with centric reordering. The numbers left of the depicted k-space lines indicate again the respective line index. The arrows at the ends of the k-space lines indicate again the direction in which the respective k-space line was scanned. All lines acquired within two corresponding shots in the centric ordering are depicted with a same type of line (continuous line, dashed line,...). The arrows on the right sides indicate the direction of the progress of the acquisition in phase-encoding direction.

As can be seen, the k-space lines in the example of figure 4 in the
first set s1' of scan data SD1 are acquired in the following order given by their index:
fist shot ("down"): 6-9-12, first shot ("up"): 6-3-0;
second shot ("down"): 7-10-13, second shot ("up"): 7-4-1;
third shot ("down"): 8-11-14, third shot ("up"): 8-5-2.

The k-space lines in the box (indices 6, 7, 8) are acquired twice in such a centric ordering scheme as is known in the art.

In this first set s1' of scan data SD1, the line indices 0, 1, 2, 6, 7, 8, 12, 13, 14 are acquired with positive polarity, i.e. in the direction of the readout direction, and the line indices 3, 4, 5, 9, 10, 11 are acquired with negative polarity, i.e. in negative readout direction.

As described herein, a second set s2' of scan data SD2 is acquired and recorded. This second set s2' of scan data SD2 can be acquired and recorded in direct succession of the acquisition and recording of the first set s1' of scan data SD1. In the example of figure 4 the k-space lines of this second set s2' of scan data are acquired in the following order given by their index:
first shot ("down"): 9-12-15, first shot ("up"): 9-6-3;
second shot ("down"): 10-13-16, second shot ("up"): 10-7-4;
third shot ("down"): 11-14-17, third shot ("up"): 11-8-5.

In this second set s2' of scan data SD2 the k-space lines in the box (indices 9, 10, 11) are acquired twice in such a centric ordering scheme as is known in the art.

In this second set s2' of scan data SD2, the line indices 3, 4, 5, 9, 10, 11, 15, 16, 17 are acquired with positive polarity, i.e. in the direction of the readout direction, and the line indices 6, 7, 8, 12, 13, 14 are acquired with negative polarity, i.e. in negative readout direction.

The shift Sh in the phase-encoding direction by which the starting point of the flyback trajectory is shifted between the recording of the first set of scan data and the second set of scan data can be chosen such that it equals a phase-shift between two consecutively recorded k-space lines in the flyback trajectory. Thus same k-space indices will be acquired and recorded in the first set s1' of scan data and in the second set s2' of scan data while the polarization of same indices acquired in the first set s1' of scan data and the second set s2' of scan data will be opposed.

The scan data of the first set of scan data SD1 and the second set of scan data SD2 can be sorted according to the direction (corresponding to the polarization A+, A- of the respective readout gradient) in which the scan data was recorded in readout direction in groups E+,E-containing only scan data recorded in one direction (block 105).

Image data BD can be reconstructed based on scan data from only one group E+ or E- or based on scan data from the first set of scan data SD1 and the second set of scan data SD2 (block 107). In particular when applied in connection with TOF, to achieve full flow compensation in the readout direction, only echoes with the same polarity E+ or E- are used in reconstruction. For other applications that are not flow-sensitive, repeated echoes acquired with opposite polarity can also be used in reconstruction for data averaging to improve the signal-to-noise ratio (SNR).

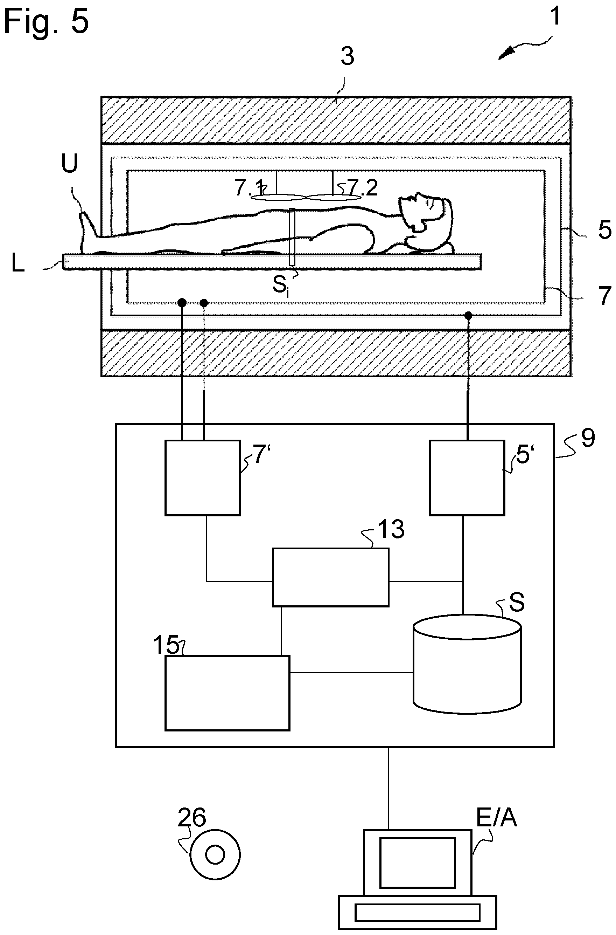

Figure 5 shows schematically a magnetic resonance system 1 according to the invention. This comprises a magnet unit 3 for generating the main magnetic field, a gradient unit 5 for generating the gradient fields, a high frequency unit 7 for radiating in and receiving high frequency signals and a control apparatus 9 configured for carrying out a method according to the invention.

In Figure 5, these subunits of the magnetic resonance system 1 are shown only roughly schematically. In particular, the high frequency unit 7 can consist of a plurality of subunits, for example, a plurality of coils such as the schematically shown coils 7.1 and 7.2 or more coils which can be configured either only to transmit radio frequency signals or only to receive the induced radio frequency signals or for both.

In order to examine an examination object U, for example, a patient or a phantom, it can be introduced on a support L into the magnetic resonance system 1, in the scanning volume thereof. The slice or the slab Si represents an exemplary target volume of the examination object from which echo signals are to be recorded and captured as scan data.

The control apparatus 9 serves to control the magnetic resonance system 1 and can, in particular, control the gradient unit 5 by means of a gradient control system 5' and the high frequency unit 7 by means of a high frequency transmitting/receiving control system 7'. The high frequency unit 7 can herein comprise a plurality of channels on which signals can be transmitted or received.

The high frequency unit 7 is responsible, together with its high frequency transmitting/receiving control system 7' for the generation and radiating-in (transmission) of a high frequency alternating field for manipulation of the spins in a region to be manipulated (for example, in slices S to be scanned) of the examination object U. Herein, the center frequency of the high frequency alternating field, also designated the B1 field, is typically adjusted so that, as far as possible, it lies close to the resonance frequency of the spin to be manipulated. Deviations of the center frequency from the resonance frequency are referred to as off-resonance. In order to generate the B1 field, in the high frequency unit 7, currents controlled by means of the high frequency transmitting/receiving control system 7' are applied to the HF coils.

Furthermore, the control apparatus 9 comprises a shift determining unit 15 with which the starting point of the flyback trajectory for the recording of the second set of scan data can be determined. The control apparatus 9 is configured overall to carry out a method according to the invention.

A computing unit 13 included in the control apparatus 9 is configured to carry out all the computation operations necessary for the required scans and determinations. Intermediate results and results needed for this or established herein can be stored in a storage unit S of the control apparatus 9. The units mentioned are herein not necessarily to be understood as physically separate units, but represent merely a subdivision into units of purpose which, however, can also be realized, for example, in fewer, or even only in one single, physical unit.

By way of an input/output apparatus E/A of the magnetic resonance system 1, for example, control commands can be passed by way of a user to the magnetic resonance system and/or results from the control apparatus 9 such as, for example, image data can be displayed.

A method described herein can also exist in the form of a computer program product which comprises a program and implements the described method on a control apparatus 9 when said program is executed on the control apparatus 9. An electronically readable data carrier 26 with electronically readable control information stored thereon can also be provided, said control information comprising at least one computer program product as described above and being configured to carry out the method described when the data carrier 26 is used in a control apparatus 9 of a magnetic resonance system 1.

Independent of the grammatical term usage, individuals with male, female or other gender identities are included within the term.

## Claims

1. A method to acquire scan data of a region of interest of an examination object by means of an echo-planar (EPI) technique, comprising the steps of:
- recording a first set of scan data in at least two shots using a flyback trajectory,
- recording a second set of scan data using the same flyback trajectory used for the first set of scan data, but with a starting point of the flyback trajectory shifted in the phase-encoding direction.

2. The method as claimed in claim 1, wherein the shift in the phase-encoding direction by which the staring point of the flyback trajectory is shifted between the recording of the first set of scan data and the second set of scan data equals a phase-shift between two consecutively recorded k-space lines in the flyback trajectory.

3. The method as claimed in any of the preceding claims, wherein the shift is induced by a pre-phaser gradient in phase-encoding direction applied before the recording of the second set of scan data using the flyback trajectory.

4. The method as claimed in any of the preceding claims, wherein the scan data of the first set of scan data and the second set of scan data are sorted according to the direction (A⁺, A) in which the scan data was recorded in readout direction in groups (E⁺,E⁻) containing only scan data recorded in one direction.

5. The method as claimed in any of the preceding claims, wherein image data is reconstructed based on scan data from only one group.

6. The method as claimed in any of the preceding claims, wherein image data is reconstructed based on scan data from the first set of scan data and the second set of scan data.

7. The method as claimed in any of the preceding claims, wherein the flyback trajectory is a flyback trajectory with linear reordering.

8. The method as claimed in any of claims 1 to 6, wherein the flyback trajectory is a flyback trajectory with centric reordering.

9. The method as claimed in any of the preceding claims, wherein the EPI technique used is a three-dimensional (3D) EPI technique.

10. The method as claimed in any of claims 1 to 8, wherein the EPI technique used is a two-dimensional (2D) EPI technique.

11. The method as claimed in any of the preceding claims, wherein at least one flow-compensation gradient is applied before an echo train within the recording of scan data of the first and/or second set of scan data, so that the acquisition of the scan data is flow-compensated.

12. The method as claimed in any of the preceding claims, wherein before the recording of the scan data a saturation band is applied to reduce inflowing signal in the readout direction.

13. A magnetic resonance system (1) comprising a magnet unit (3), a gradient unit (5), a high frequency unit (7) and a control apparatus (9) with a high frequency transmitting/receiving control system (7') and with a shift unit (15), wherein the control apparatus (9) is configured to carry out a method as claimed in one of claims 1 to 12 on the magnetic resonance system (1).

14. A computer program which is able to be loaded directly into a memory store of a control apparatus (9) of a magnetic resonance system (1), having program means in order to carry out the steps of the method as claimed in one of claims 1 to 12 when the program is executed in the control apparatus (9) of the magnetic resonance system (1).

15. An electronically readable data carrier with electronically readable control information stored thereon which comprises at least one computer program as claimed in claim 14 and is configured such that, when the data carrier is used in a control apparatus (9) of a magnetic resonance system (1), said control information carries out a method as claimed in one of claims 1 to 12.
